## Europäisches Patentamt

## European Patent Office

## Office européen des brevets

(11) Numéro de publication: **0 190 974**
**B1**

# FASCICULE DE BREVET EUROPEEN

(45) Date de publication du fascicule du brevet:
26.04.89

(51) Int. Cl.⁴: **H03F 3/45**

(21) Numéro de dépôt: 86400218.3

(22) Date de dépôt: 03.02.86

(54) Amplificateur différentiel de courant.

(30) Priorité: 05.02.85 FR 8501585

(43) Date de publication de la demande:
13.08.86 Bulletin 86/33

(45) Mention de la délivrance du brevet:
26.04.89 Bulletin 89/17

(84) Etats contractants désignés:
BE DE FR GB IT NL SE

(56) Documents cités:
EP-A- 0 039 076
DE-A- 3 304 814
US-A- 4 138 649
US-A- 4 392 112

JOURNAL OF PHYSICS E: SCIENTIFIC INSTRUMENTS,
vol. 17, no. 6, juin 1984, pages 472-476, The Institute of
Physics, Dorking, GB; D.J. MAPPS et al.:
"Magnetostriction harmonics measurement using a
double piezoelectric transducer technique"
ELECTRONICS, vol. 41, no. 9, 29 avril 1968,
pages 58-64, New York, US; R.I. DEMROW: "Protecting
data from the ground up"

(73) Titulaire: THOMSON-CSF, 173, Boulevard Haussmann,
F-75379 Paris Cédex 08(FR)

(72) Inventeur: Lemaire, Frédéric, THOMSON-CSF
SCPI 19, avenue de Messine, F-75008 Paris(FR)

(74) Mandataire: Rinuy, Santarelli et al, 14, avenue de la
Grande Armée, F-75017 Paris(FR)

**Description**

La présente invention concerne les amplificateurs différentiels de courant, c'est-à-dire des amplificateurs susceptibles de recevoir un courant I1 sur une première borne d'entrée et un courant I2 sur une deuxième borne d'entrée, pour produire en sortie un courant proportionnel à I1–I2.

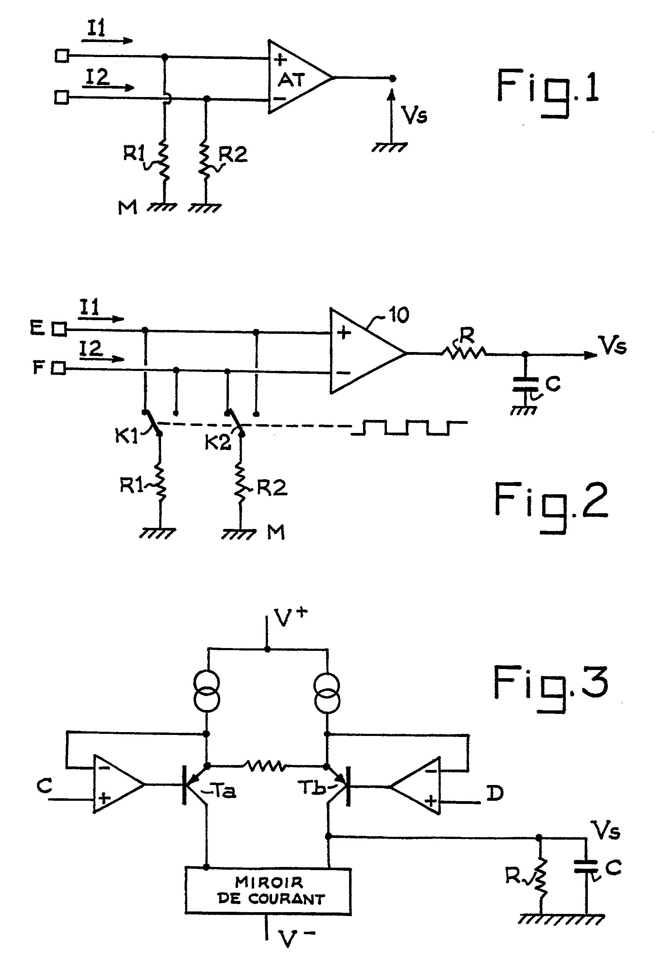

On sait réaliser ce type d'amplificateur par exemple à l'aide d'un schéma tel que celui de la figure 1: le courant I1 est appliqué à une résistance R1 et le courant I2 à une résistance R2 de même valeur que R1. La différence des chutes de tension R1I1 et R2I2 dans ces résistances est mesurée par un amplificateur différentiel de tension AT. On sait bien réaliser des amplificateurs de tension ayant une bonne réjection de mode commun. La tension de sortie de l'amplificateur est proportionnelle à R1I1–R2I2.

Si R1 est bien égale à R2 il n'y a pas de problème. Mais en pratique il est difficile de réaliser des résistances suffisamment précises, notamment si l'amplificateur de courant doit être réalisé sous forme de circuit intégré. Il apparaîtra dans le signal de sortie une composante de mode commun due à la différence de valeur des résistances (composante proportionnelle à la valeur moyenne des courants et à la différence R1–R2).

La précision est donc directement liée à l'appairage des résistances.

La présente invention propose un schéma d'amplificateur de courant qui évite ce défaut en permettant de faire une mesure différentielle très précise aussi bien pour des courants continus que pour des courants alternatifs.

Pour cela, l'invention propose un amplificateur différentiel de courant ayant deux entrées recevant chacune un courant d'entrée respectif, pour produire en sortie un signal proportionnel à la différence des courants d'entrée, comprenant deux résistances reliées à un même nœud de circuit et ayant sensiblement la même valeur, des connexions entre les entrées de l'amplificateur de courant et les résistances, et un moyen pour établir dans la résistance R1 une chute de tension variant comme le produit R1I1 et dans la résistance R2 une chute de tension variant comme R2I2, les résistances étant par ailleurs reliées chacune à une entrée d'un amplificateur différentiel de tension, caractérisé en ce qu'il est prévu des moyens de commutation périodiques actionnés avec un rapport cyclique voisin de 0,5 pour:

1) intervertir les connexions entre les entrées de l'amplificateur de courant et les résistances pendant la moitié de chaque cycle de commutation, de manière à produire pendant cette moitié de cycle une chute de tension variant comme R1I2 dans la résistance R1 et une chute de tension variant comme R2I1 dans la résistance R2,

2) intervertir également les connexions entre les résistances et les entrées de l'amplificateur pendant cette moitié de cycle.

Par chute de tension variant "comme R1I1" (ou R1I2, ou R2I2, ou R2I1), on entend notamment une chute de tension R1I1 ou – R1I1, mais aussi R1(I0+I1) où I0 est une constante, ou encore R1(I0–I1) etc.,

l'essentiel étant qu'on puisse facilement établir deux chutes de tension, (par exemple R1(I0–I1) et R1(I0–I2), dont la différence, ici R1(I1–I2), se ramène à une valeur proportionnelle à I1–I2.

D'autres caractéristiques et avantages de l'invention apparaîtront à la lecture de la description détaillée qui suit et qui est faite en référence aux dessins annexés dans lesquels:

– la figure 1 déjà mentionnée représente la technique antérieure,

– la figure 2 représente un schéma de principe d'amplificateur de courant,

– la figure 3 représente à titre d'exemple seulement un amplificateur différentiel de tension,

– la figure 4 représente un schéma particulier de réalisation permettant l'amplification différentielle de courants sortant des bornes d'entrée,

– la figure 5 représente un schéma particulier de réalisation permettant l'amplification différentielle de courants entrant ou sortant sur les bornes d'entrée.

L'amplificateur différentiel de courant de la figure 2 comprend deux bornes d'entrée E et F.

Les bornes E et F sont reliées aux entrées d'un amplificateur différentiel de tension 10 ayant une forte impédance d'entrée et ayant une bonne réjection de mode commun (ce que l'on sait bien faire pour un amplificateur différentiel de tension).

Deux résistances R1 et R2, reliées d'un côté à un même nœud de circuit qui peut être une masse M, sont reliées d'un autre côté l'une (R1) à un premier commutateur K1 et l'autre (R2) à un second commutateur K2. Les commutateurs sont actionnés périodiquement en phase l'un avec l'autre avec un rapport cyclique de commutation voisin de 0,5 c'est-à-dire qu'ils sont dans un premier état pendant une demi période de la fréquence de commutation et dans un second état pendant la demi période suivante.

Le commutateur double K1 permet de relier la résistance R1 soit à la borne E soit à la borne F.

Le commutateur double K2 permet de relier la résistance R2 soit à la borne F soit à la borne E.

Lorsque la résistance R1 est reliée à la borne E, la résistance R2 est reliée à la borne F et réciproquement.

Un courant d'entrée I1 est injecté par la borne E et un autre courant d'entrée I2 est injecté par la borne F.

L'amplificateur différentiel de tension a par exemple (pour simplifier) un gain unitaire.

Dans ce cas, il produit à sa sortie une tension qui est R1I1–R2I2 pendant une première demi période et R2I2–R1I2 pendant la demi période suivante.

Pour analyser le courant moyen I1–I2, on place en sortie de l'amplificateur de tension un filtre passe-bas RC qui lisse les variations dues à la commutation. La tension moyenne aux bornes de la capacité est alors

$$\left(\frac{R1 + R2}{2}\right)(I1-I2).$$

Même si R1 et R2 ne sont pas égales il n'y a pas (au premier ordre) de composante de mode commun due à la différence de valeur des résistances.

On s'arrangera cependant pour réaliser des valeur R1 et R2 aussi égales que possible pour éviter une composante de mode commun qui serait due par exemple à un rapport cyclique de commutation non égal à 0,5. Ainsi, il y a bien une amplification purement différentielle des courants I1 et I2, les composantes de mode commun n'existant qu'au second ordre.

Si les courants I1 et I2 sont alternatifs, on choisira la fréquence de commutation des commutateurs plus élevée que la fréquence des signaux I1 et I2.

Dans certains cas très particulier, on peut prévoir qu'il n'y a pas de lissage de la tension de sortie de l'amplificateur de tension par un filtre RC.

Par exemple cela peut se produire lorsque les courants d'entrée I1 et I2 sont alternatifs, qu'ils ont une même fréquence f connue et que l'on effectue une commutation des commutateurs K1 et K2 justement à la fréquence f, par exemple dans le but de détecter une composante continue dans le signal alternatif I1–I2: on peut dans ce cas convertir la tension de sortie de l'amplificateur de tension en un courant et appliquer ce courant à un condensateur; puis on échantillonne la tension aux bornes du condensateur à la fréquence f. La croissance ou la décroissance de cette tension échantillonée est une mesure de la composante continue de la différence des courants I1 et I2.

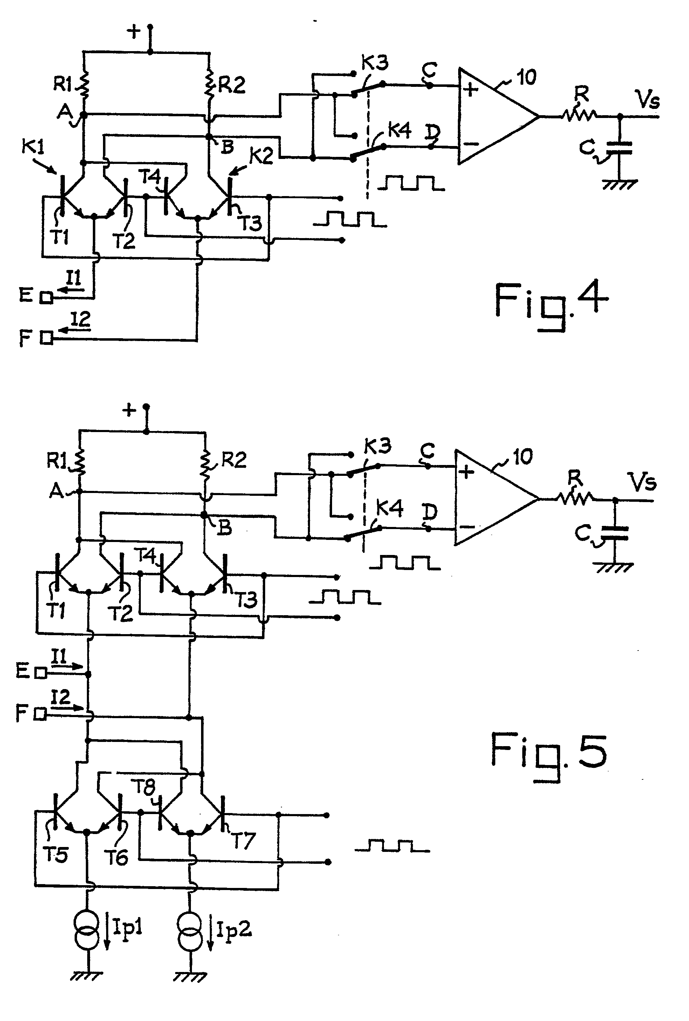

La figure 3 représente à titre d'exemple seulement une structure d'amplificateur de tension à bonne réjection de mode commun utilisable dans le schéma de la figure 2. Il comprend un étage différentiel de sortie à deux transistors Ta et Tb parcourus par des courants égaux en l'absence de signal d'entrée et parcourus par des courants différents en présence d'un signal d'entrée, la différence des courants étant proportionnelle au signal et étant appliquée à un réseau RC parallèle relié au collecteur de l'un des transistors. La tension aux bornes de ce réseau constitue la tension de sortie de l'amplificateur et n'a pas besoin d'être filtrée par un autre réseau RC. Les entrées de cet amplificateur de tension sont les bases des transistors Ta et Tb, éventuellement précédées chacune d'un autre étage différentiel à grande impédance d'entrée, l'une des entrées de cet autre étage étant rebouclée sur l'émetteur du transistor Ta (ou Tb).

La figure 4 représente un exemple concret de réalisation de l'amplificateur de courant.

Dans cet exemple, au lieu que les bornes d'entrée E et F recevant les courants I1 et I2 (courants sortants dans ce cas) soient directement connectées aux entrées de l'amplificateur de tension, elles sont connectées à ces entrées par l'intermédiaire de deux groupes de commutateurs.

Le premier groupe comprend un commutateur K1 et un commutateur K2. Le commutateur K1 comprend un transistor T1 relié entre la borne E et la résistance R1 et un transistor T2 relié entre la borne E et la résistance R2. Le commutateur K2 comprend un transistor T4 relié entre la borne F et la résistance R1 et un transistor T3 relié entre la borne F et la résistance R2. Les transistors T1 et T3 sont rendus conducteurs pendant une demi-alternance de la fréquence de commutation des commutateurs et bloqués pendant l'autre demi-alternance. Les transistors T2 et T4 sont rendus conducteurs et bloqués en opposition de phase avec les transistors T1 et T3.

Les résistances R1 et R2 sont reliées par ailleurs à un même nœud de circuit.

Le deuxième groupe de commutateurs comprend un commutateur K3 et un commutateur K4 actionnés à la même fréquence de commutation. Le commutateur K3 permet de relier une entrée C de l'amplificateur différentiel de tension soit au point de jonction A de la résistance R1 et des transistors T1 et T4 pendant la demi alternance où T1 et T3 sont conducteurs soit au point de jonction B de la résistance R2 et des transistors T2 et T3 pendant la demi-alternance ou T2 et T4 sont conducteurs.

Le commutateur K4 permet de relier l'autre entrée D de l'amplificateur differentiel de tension soit au point de jonction A pendant que T2 et T4 sont conducteurs soit au point B pendant que T1 et T3 sont conducteurs.

La différence moyenne des chutes de tension dans R1 et R2 est la même qu'à la figure 2.

Dans une autre variante de réalisation représentée à la figure 5, on conserve intégralement le schéma de la figure 4 et on y rajoute les éléments suivants: la borne E est reliée à un transistor T5 et à un transistor T8. Le transistor T5 est relié entre la borne E et une source de courant Ip1; le transistor T8 est relié entre la borne E et une source de courant Ip2. La borne F est reliée à un transistor T6 et un transistor T7. Le transistor T6 est relié entre la borne F et la source de courant Ip1; le transistor T7 est relié entre la borne F et la source de courant Ip2.

Les transistors T5 et T7 sont rendus conducteurs et bloqués en phase avec les transistors T1 et T3; les transistors T6 et T8 en phase avec les transistors T2 et T4.

Dans ces conditions, la résistance R1 est parcourue par un courant Ip1–I1 pendant une demi-alternance et par un courant Ip1–I2 pendant la demi-alternance suivante.

Réciproquement la résistance R2 est d'abord parcourue par le courant Ip2–I2 (première demi-alternance) puis par le courant Ip2– I1.

La différence des chutes de tension dans R1 et dans R2 est donc d'abord R2(Ip2–I2) – R1(Ip1–I1) puis R2(Ip2–I1) – R1(Ip1–I2), mais cette dernière valeur est inversée aux bornes de l'amplificateur de tension pendant la deuxième demi-alternance (par les commutateurs K3 et K4).

En moyenne, la tension différentielle aux bornes d'entrée de l'amplificateur de tension est donc égale à:

$$\tfrac{1}{2}(R2(Ip2–I2) – R1(Ip1–I1) + R1(Ip1–I2) – R2(Ip2–I1)$$

soit $\tfrac{1}{2}(R1+R2)$ (I1–I2).

Là encore, l'erreur sur l'égalité des résistances R1 et R2 n'intervient pas au premier ordre. De même l'erreur sur l'égalité des courants Ip1 et Ip2 que l'on choisit cependant de préférence égaux.

La réjection de mode commun là encore, n'est limitée que par les performances de l'amplificateur de tension si les résistances R1 et R2, les courants Ip1

et lp2, et les demi-alternances du cycle de commutation, sont aussi bien appairés que possible.

## Revendications

1. Amplificateur différentiel de courant ayant deux entrées (E, F) recevant chacune un courant d'entrée respectif(I1 et I2), pour produire en sortie un signal proportionnel à la différence des courants d'entrée, comprenant deux résistances (R1 et R2) reliées à un même nœud (M) de circuit et ayant sensiblement la même valeur, des connexions entre les entrées de l'amplificateur de courant et les résistances, et des moyens de commutation pour établir dans la résistance R1 une chute de tension variant comme le produit R1I1 et dans la résistance R2 une chute de tension variant comme R2I2, les résistances étant par ailleurs reliées chacune à une entrée d'un amplificateur différentiel de tension (10), caractérisé en ce que les dits moyens de commutation (K1, K2, K3, K4) sont actionnés periodiquement avec un rapport cyclique voisin de 0,5 pour:
1) intervertir les connexions entre les entrées de l'amplificateur de courant et les résistances pendant la moitié de chaque cycle de commutation, de manière à produire pendant cette moitié de cycle une chute de tension variant comme R1I2 dans la résistance R1 et une chute de tension variant comme R2I1 dans la résistance R2,
2) intervertir également les connexions entre les résistances et les entrées de l'amplificateur différentiel de tension pendant cette moitié de cycle.

2. Amplificateur différentiel selon la revendication 1, caractérisé en ce que les courants d'entrée I1 et I2 sont directement appliqués à la résistance R1 et la résistance R2 respectivement pendant une première moitié de cycle et appliqués à la résistance R2 et la résistance R1 respectivement pendant une deuxième moitié de cycle.

3. Amplificateur différentiel selon la revendication 2, caractérisé en ce que les résistances sont parcourues chacune par un courant qui est la différence entre un courant fixe (Ip1, Ip2) et l'un des courants d'entrée (I1, I2).

4. Amplificateur différentiel selon l'une quelconque des revendications 1 à 3, caractérisé en ce que la première résistance (R1) est reliée à un premier transistor (T1) et à un second transistor (T4) reliés respectivement à la première entrée (E) et à la seconde entrée (F) de l'amplificateur de courant, la deuxième résistance (R2) est reliée à un troisième transistor (T2) et un quatrième transistor (T3) reliés respectivement à la deuxième et la première entrée de l'amplificateur de courant, les résistances étant reliées par ailleurs par un commutateur double aux entrées de l'amplificateur de tension, les transistors et le commutateur étant commutés périodiquement en alternance de phase avec un rapport cyclique voisin de 0,5, les premier et quatrième transistors étant rendus conducteurs pendant une première moitié du cycle périodique et bloqués pendant l'autre moitié et inversement les deuxième et troisième transistors étant bloqués pendant la première moitié et conducteurs pendant la deuxième, le commutateur double inversant les connexions entre la résistance et les entrées de l'amplificateur à chaque demi-alternance.

## Patentansprüche

1. Stromdifferenzverstärker mit zwei Eingängen (E, F), in die jeweils ein Eingangsstrom (I1, I2) eingespeist wird, wobei als Ausgang ein Signal proportional zur Differenz der beiden Eingangsströme erzeugt wird, mit zwei Widerständen (R1 und R2), die mit einem gleichen Knotenpunkt (M) verbunden sind und annähernd denselben Wert aufweisen, mit einer Verbindung zwischen den Eingängen des Stromverstärkers und den Widerständen und mit Umschaltmitteln zur Erzeugung eines wie das Produkt R1I1 variierenden Spannungsabfalls am Widerstand R1 und eines Spannungsabfalls am Widerstand R2, der wie das Produkt R1I2 variiert, wobei jeder Widerstand jeweils mit einem Eingang eines Spannungsdifferenzverstärkers (10) verbunden ist, dadurch gekennzeichnet, daß die Umschaltmittel (K1, K2, K3, K4) periodisch in einem zyklischen Verhältnis von annähernd 0,5 betätigt werden, um:
1) während der Hälfte jedes Umschaltzyklus die Verbindungen zwischen den Eingängen des Stromverstärkers und den Widerständen derart zu vertauschen, daß während dieser Zyklushälfte am Widerstand R1 ein Spannungsabfall erzeugt wird, der wie R1I2 variiert, und am Widerstand R2 ein Spannungsabfall, der wie R2I1 variiert, und um ferner
2) während dieser Zyklushälfte die Verbindungen zwischen den Widerständen und den Eingängen des Spannungsdifferenzverstärkers ebenfalls zu vertauschen.

2. Stromdifferenzverstärker nach Anspruch 1, dadurch gekennzeichnet, daß die Eingangsströme I1 und I2 während einer ersten Zyklushälfte jeweils direkt in den Widerstand R1 bzw. den Widerstand R2 und während einer zweiten Zyklushälfte jeweils direkt in den Widerstand R2 bzw. den Widerstand R1 eingespeist werden.

3. Stromdifferenzverstärker nach Anspruch 2, dadurch gekennzeichnet, daß die Widerstände jeweils von einem Strom durchlaufen werden, der die Differenz zwischen einem festen Strom (Ip1, Ip2) und einem der Eingangsströme (I1, I2) darstellt.

4. Stromdifferenzverstärker nach einem der Ansprüche 1 bis 3, dadurch gekennzeichnet, daß der erste Widerstand (R1) mit einem ersten Transistor (T1) sowie einem zweiten Transistor (T4), die jeweils mit dem ersten Eingang (E) bzw. mit dem zweiten Eingang (F) des Stromverstärkers verbunden sind, und der zweite Widerstand (R2) mit einem dritten Transistor (T2) sowie einem vierten Transistor (T3), die jeweils mit dem zweiten bzw. dem ersten Eingang des Stromverstärkers verbunden sind, verbunden ist, wobei die Widerstände andererseits über einen Doppelschalter mit den Eingängen des Spannungsverstärkers verbunden sind und die Transistoren sowie der Schalter periodisch im Phasenwechsel mit einem zyklischen Verhältnis von annähernd 0,5 umgeschaltet werden, wobei der erste und vierte Transistor während einer ersten Hälfte des periodischen Zyklus leitend gemacht und während dessen anderer Hälfte gesperrt und umgekehrt der zweite und dritte Transistor während der ersten Hälfte gesperrt und während der zweiten Hälfte leitend sind, und wobei der Doppelschalter bei jedem halben Phasenwechsel die Verbindungen zwischen den Widerständen und den Eingängen des Verstärkers vertauscht.

**Claims**

1. A differential current amplifier having two inputs (E, F) each receiving a repective input current (I1 and I2) to produce at the output a signal proportional to the difference between the input currents, comprising two resistances (R1 and R2) connected to the same current supply source (M) and having substantially the same value, connections between the inputs of the current amplifier and the resistances, and commutation means to produce in resistance R1 a voltage drop varying like the product R1I1 and in resistance R2 a voltage drop varying like R2I2, the resistances also each being connected to an input of a differential voltage amplifier (10), characterized in that the said means of commutation (K1, K2, K3, K4) are operated periodically with a cyclic relationship close to 0.5 in order to:
1) reverse the connections between the inputs of the current amplifier and the resistances during half of each cycle of commutation so as to produce during this half of a cycle a voltage drop varying like R1I2 in the resistance R1 and a voltage drop varying like R2I1 in the resistance R2,
2) likewise reverse the connections between the resistances and the inputs of the differential voltage amplifier during this half of a cycle.

2. A differential amplifier according to Claim 1, characterized in that the input currents I1 and I2 are directly applied to the resistance R1 and the resistance R2 respectively during a first half of a cycle and applied to the resistance R2 and the resistance R1 respectively during a second half of the cycle.

3. A differential amplifier according to Claim 2, characterized in that each resistance has a current flowing through it which is the difference between a fixed current (Ip1, Ip2) and one of the input currents (I1, I2).

4. A differential amplifier according to any one of Claims 1 to 3, characterized in that the first resistance (R1) is connected to a first transistor (T1) and to a second transistor (T4) connected respectively to the first input (E) and to the second input (F) of the current amplifier, the second resistance (R2) is connected to a third transistor (T2) and to a fourth transistor (T3) connected respectively to the second and the first input of the current amplifier, the resistances also being connected through a double commutator to the inputs of the voltage amplifier, the transistors and the commutator being switched periodically with an alternation in phase having a cyclic relationship close to 0.5, the first and fourth transistors being made conductors during a first half of the periodic cycle and blocked during the other half and conversely the second and third transistors being blocked during the first half and conducting during the second, the double commutator reversing the connections between the resistances and the amplifier inputs at each half-alternation.

Fig.1

Fig.2

Fig.3

Fig.4

Fig.5